Europäisches Patentamt

European Patent Office

Office européen des brevets

(11) Veröffentlichungsnummer: **0 058 244**

A2

(12) **EUROPÄISCHE PATENTANMELDUNG**

(21) Anmeldenummer: 81109283.2

(22) Anmeldetag: 29.10.81

(51) Int. Cl.³: **G 11 C 11/24**
**G 11 C 11/34**

(30) Priorität: 06.02.81 DE 3104150

(43) Veröffentlichungstag der Anmeldung:
25.08.82 Patentblatt 82/34

(84) Benannte Vertragsstaaten:
DE FR GB

(71) Anmelder: SIEMENS AKTIENGESELLSCHAFT Berlin
und München
Postfach 22 02 61
D-8000 München 22(DE)

(72) Erfinder: Hoffmann, Kurt, Dr.
Nelkenweg 20
D-8021 Taufkirchen(DE)

(72) Erfinder: Seher, Eugen
Sindelfinger Weg 9
D-7031 Grafenau 1(DE)

(54) Monolithisch integrierter MOS-Halbleiterspeicher.

(57) Bei monolithisch integrierten MOS-Halbleiterspeichern, insbesondere bei dynamischen MOS-Halbleiterspeichern, werden die Gates der der in den einzelnen Speicherzellen der Speichermatrix vorgesehenen Schalttransistoren bzw. Schalt-Speichertransistoren zeilenweise über eine der betreffenden Zeile der Speichermatrix zugeordnete Wortleitung WL zusammengefaßt und über diese Wortleitung gemeinsam adressiert. Da diese Wortleitungen WL im Gegensatz zu den Bitleitungen der Speichermatrix ausschließlich kapazitiv mit dem Halbleiterbereich der Speichermatrix gekoppelt sind, können die von den einzelnen Adressiervorgängen herrührenden Restladungen nicht rasch genug abfließen, was zu Betriebsstörungen bzw. zu einer Verfälschung der im Speicher eingegebenen Informationen führen kann. Es sind deshalb auch bei bekannten RAM-Speichern dieser Art Maßnahmen vorgesehen, welche für einen raschen Abfluß der parasitären Restladungen sorgen. Die bekannten Schaltungen haben jedoch den Nachteil, daß sie entweder auch bei sich im adressierten Zustand befindlichen Wortleitungen betätigen und damit zu störenden Beeinträchtigungen des Adressiersignals in der betreffenden Wortleitung führen, oder daß sie sich schlecht in das Layout der Speichermatrix einpassen und demnach einen erheblichen Aufwand an Chip-Fläche erfordern. Diese Nachteile werden vermieden, wenn man gemäß der vorliegenden Erfindung über die Serienschaltung zweier durch dieselbe Signalspannung $U_1$ gleichzeitig gesteuerter MOS-Feldeffekttransistoren mit dem Bezugspotential verbindet und außerdem einen zwischen den beiden Transistoren befindlichen Schaltungspunkt A über einen dritten MOS-Transistor über einen als Widerstand geschalteten weiteren MOS-Transistor an das andere Betriebspotential des Speichers legt.

## FIG 3

Siemens Aktiengesellschaft    Unser Zeichen
Berlin und München           VPA 81 P 1013 E

Monolithisch integrierter MOS-Halbleiterspeicher

Die Erfindung betrifft einen monolithisch integrierten MOS-Halbleiterspeicher, bei dem die in Form einer Speichermatrix in dem den Speicher aufnehmenden Halbleiterkörper angeordneten MOS-Speicherelemente einerseits über die spaltenparallel geführten Bitleitungen und andererseits über die zeilenparallel geführten Wortleitungen einzeln durch Dekoder adressierbar sind, bei dem die einzelnen Wortleitungen im Gegensatz zu den Bitleitungen ausschließlich kapazitiv mit den zugehörigen Speicherelementen gekoppelt sind, und bei dem zum Beispiel die Zuführung der Adressiersignale zu den einzelnen Wortleitungen unter Vermittlung einer Treiberstufe erfolgt.

Halbleiterspeicher dieser Art sind üblich und können entweder mit nicht flüchtigen MOS-Speicherzellen oder mit flüchtigen MOS-Speicherzellen ausgestattet sein. Ein Beispiel für Speicher mit nichtflüchtigen Speicherzellen bilden Speicher mit Ein-Transistor-Speicherzellen, deren Transistoren ein geschichtetes Gatedielektrikum oder ein schwebendes Gate aufweisen, während Speicher mit Ein-Transistor-Speicherzellen, bei denen die Transistoren mit einer homogenen Gateisolation ausgestattet sind, bezüglich der in ihnen gespeicherten Information flüchtig sind und demgemäß einer Auffrischung der in ihnen gespeicherten Information bedürfen.

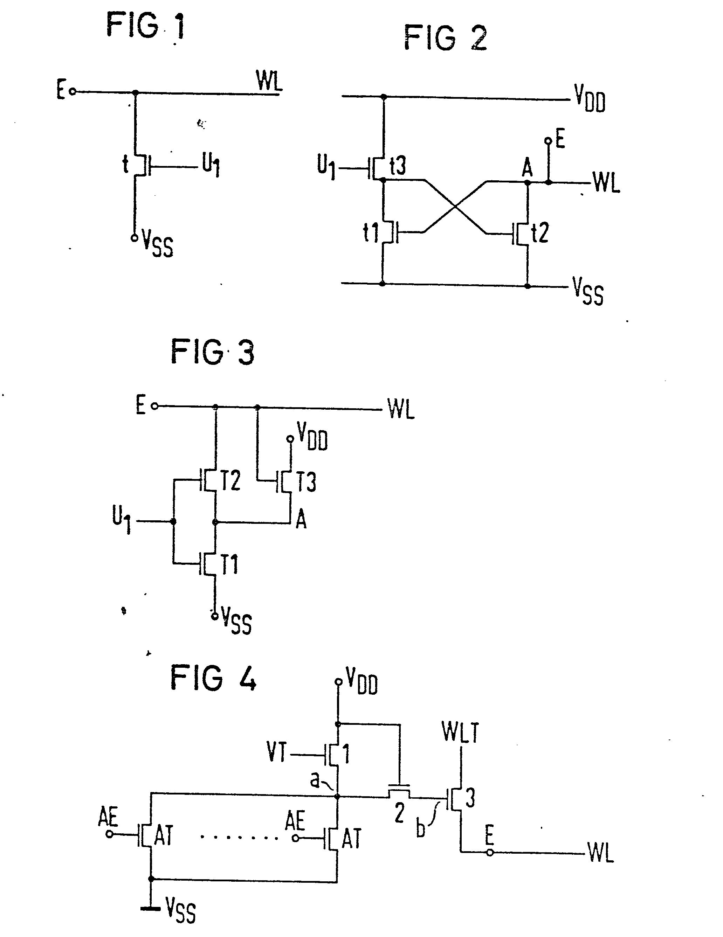

Bei Speichern der eingangs definierten Art ist es angebracht, wenn man für ein definiertes Verhalten der Wortleitungspotentiale sorgt, d.h. also, die sog. "schwebenden Wortleitungen" vermeidet. Die hierzu bekannten Möglichkeiten sind in Figur 1 und in Figur 3 dargestellt.

Jeder der beiden in Fig. 1 und in Fig. 2 dargestellten
Möglichkeiten haftet ein spezifischer Nachteil an. Es
ist deshalb Aufgabe der Erfindung, eine Möglichkeit
anzugeben, welche die Nachteile der bekannten Lösungen
vermeidet.

Erfindungsgemäß wird für einen monolithisch integrierten Halbleiterspeicher der eingangs definierten Art vorgeschlagen, daß jede Wortleitung über die Serienschaltung zweier MOS-Feldeffekttransistoren an ein festes
Betriebspotential der Schaltung gelegt und die beiden
MOS-Feldeffekttransistoren simultan gesteuert sind, daß
außerdem ein Schaltungspunkt zwischen den Source-Drainstrecken der beiden MOS-Feldeffekttransistoren über die
Source-Drainstrecke eines dritten MOS-Feldeffekttransistors an ein zweites festes Betriebspotential gelegt ist
und daß schließlich die Gateelektrode des dritten MOS-
Feldeffekttransistors mit der betreffenden Wortleitung
unmittelbar verbunden ist.

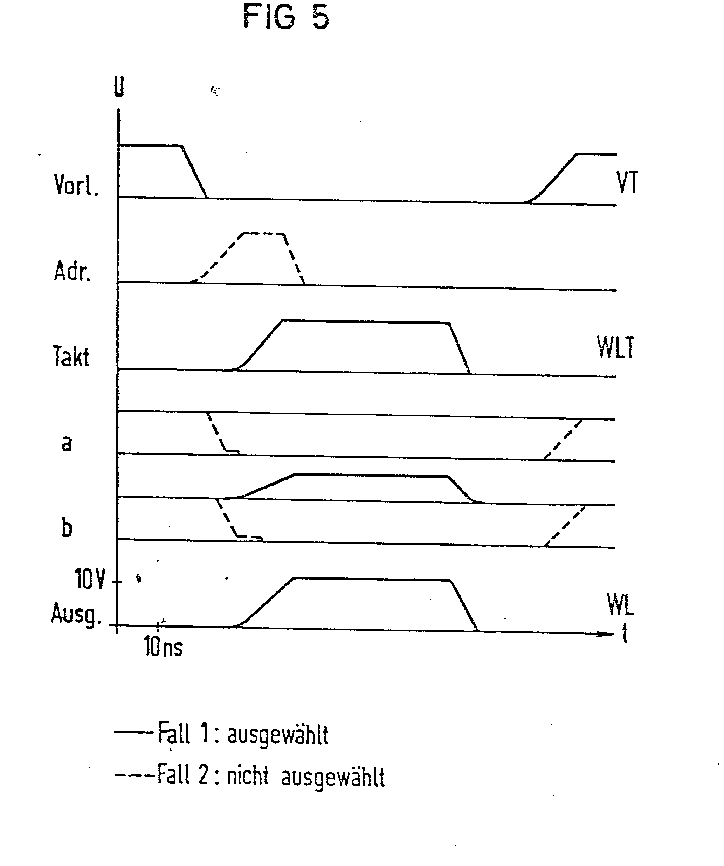

Die bekannten Lösungen werden nun anhand der Figuren 1
und 2 und dann die erfindungsgemäße Lösung anhand von
3, 4 und 5 näher vorgestellt. Dabei wird anhand von
Figur 4 und 5 eine in Kombination mit der Erfindung
geeignete Ansteuerung der einzelnen Wortleitungen gezeigt, wobei jedoch zu bemerken ist, daß diese Ansteuerung für die vorliegende Erfindung nicht spezifisch ist.

Bei der ersten bekannten und in Figur 1 dargestellten
Lösung wird jeder Wortleitung WL an geeigneter Stelle,
insbesondere an deren Anfang oder an deren Ende, je
ein selbstsperrender MOS-Feldeffekttransistor t zugeordnet, indem dessen Drain mit der besagten Wortleitung
WL leitend verbunden und dessen Source mit einem der
beiden Betriebspotentiale, insbesondere mit dem Bezugspotential $V_{ss}$ leitend verbunden und in diesem Falle geerdet ist. Das an die Gateelektrode dieses Entladungstransistors t zu legende Potential $U_1$ muß der Bedingung
$$U_T < U_1 \leqq V_{DD}$$
genügen. Dabei ist $U_T$ die Schwellspannung (also die zwischen Gate und Source des Transistors t zu legende und für das Ansprechen des Transistors erforderliche Mindestspannung) und $V_{DD}$ das Betriebspotential gegenüber dem Bezugspotential (Masse) bedeutet. Zu bemerken ist außerdem, daß die Transistoren bei den dargestellten Schaltungsbeispielen sämtlich selbstsperrend und außerdem vom selben Kanaltyp, insbesondere vom n-Kanaltyp, sind.

Die Steuerspannung $U_T$ für den Entladetransistor t ist zwischen dessen Sourceanschluß und Gateanschluß gelegt. Sie kann permanent angelegt oder auch in Form von Taktimpulsesn zugeführt wein. E ist der Adressiereingang der zugeordneten Wortleitung WL.

Bei der bekannten Lösung gemäß Figur 2 ist jede Wortleitung WL an den einen Ausgang je eines RS-Flip-Flops t1, t2 gelegt, während der andere Ausgang dieses Flip-Flopsüber die Source-Drainstrecke eines weiteren MOS-Feldeffekttransistors t3 mit dem ersten Betriebspotential $V_{DD}$ verbunden ist. Die Sourceanschlüsse der beiden das RS-Flip-Flop bildenden MOS-Transistoren t1 und t2, die über ihre Gate- und Sourceanschlüsse miteinander kreuzgekoppelt sind, liegen hingegen an Masse, also am Bezugspotential $V_{SS}$. E ist wiederum der Adressiereingang der betreffenden Wortleitung WL. Die erforderliche Bedingung für die an das Gate des Transistors t3, also des Entladungstransistors, zu legende Steuerspannung $U_T$ ist in diesem Falle
$$2U_T < U_1 < V_{DD}.$$
Es ist aber auch ein getakteter Betrieb möglich.

Der in Figur 1 dargestellten Lösung haftet der Nachteil an, daß ein Ladungsabfluß auch aus der ausgewählten Wort-

. 0058244

leitung über den ihr zugeordneten Entladetransistor t stattfindet. Dort ist er aber unerwünscht, weil dadurch die Betriebssicherheit des Speichers in Mitleidenschaft gezogen wird. Bei der bekannten Lösung gemäß Figur 2 ist dieser Nachteil zwar vermieden. Es treten jedoch geometrische Probleme im Layout auf, weil sich eine solche Schaltung nur schwer im Wortleitungsraster unterbringen läßt, d.h. also mit anderen Worten zu unausgenutzten Bereichen der Halbleiteroberfläche im Gebiet der Speichermatrix führt.

Die gemäß der Erfindung vorgeschlagene Lösung sieht, wie auch in Figur 3 dargestellt, die Serienschaltung zweier MOS-Feldeffekttransistoren T1 und T2 zwischen der jeweils zu schützenden Wortleitung WL und dem einen Betriebspotential, insbesondere dem Bezugspotential $V_{ss}$, vor. Das Steuersignal U1 (bezogen auf das Bezugspotential $V_{ss}$) wird den Gates der beiden Transistoren T1 und T2 gleichzeitig zugeführt. Ein dritter MOS-Feldeffekttransistor T3 vomselben Typ wie die beiden Transistoren T1 und T2 bildet eine Brücke zum anderen Betriebspotential, insbesondere dem ersten Betriebspotential $V_{DD}$. Das Gate dieses dritten Transistors T3 liegt an der jeweils zu schützenden Wortleitung WL. E ist wiederum der Adressiereingang der betreffenden Wortleitung WL.

Ersichtlich weist die Schaltung zwei Betriebszustände auf, je nachdem, ob die betreffende Wortleitung durch ein Adressiersignal ausgewählt oder ob sie im Ruhezustand ist. Im ersten Fall liegt die betreffende Wortleitung am Pegel "H", im zweiten Fall am Pegel "L". (H = High = Zustand logisch "1" und L = Low = Zustand logisch "0".)

Zu bemerken ist, daß hinsichtlich der Steuerspannung $U_1$ für die beiden MOS-Feldeffekttransistoren T1 und T2 die

Bedingung

$$U_T < U_1 < |V_{DD} - U_T|$$

bei statischem Betrieb (d.h. bei beständig offenen Transistoren T1, T2, T3) zu beachten ist. Andernfalls wird die Zuführung des Signals $U_1$ in Form von getakteten Impulsen empfohlen.

Die Transistoren T1, T2 und T3 sind bevorzugt vom n-Kanaltyp und selbstsperrend, wie bereits oben angegeben wurde.

Liegt die zu schützende Wortleitung WL wegen des nicht ausgewählten Zustandes am Pegel "L", so ist der Transistor T3 gesperrt. Eventuell auf die Wortleitung WL eingekoppelte Signale werden über die Reihenschaltung der beiden Transistoren T1 und T2 nach Masse abgeleitet. Das Potential an der Wortleitung WL ist dabei so niedrig, daß die Einsatzspannung des Transistors T3 nicht überschritten wird und dieser Transistor deshalb gesperrt ist.

Liegt dann die Wortleitung WL infolge des ihr zugeführten Auswahlsignals am Pegel "H", so ist der Transistor T3 leitend. Dadurch wird die Spannung zwischen dem Sourceanschluß A und dem Bezugspotential $V_{SS}$ größer als $U_1 - U_T$, so daß der Transistor T2 nichtleitend wird. Damit wird der Wortleitung WL keine Ladung mehr entzogen, so daß der durch die erfindungsgemäße Schaltung gewährleistete Bootstrap-Effekt eine Erhöhung der Spannung der Wortleitung WL zum Bezugspotential über die Betriebsspannung $V_{DD}$ hinaus erlaubt.

Damit wird ein effektiver Schutz der Wortleitung WL in dem angegebenen Sinn mindestens in einem Ausmaß erreicht, wie er bei Anwendung einer Schaltung gemäß Figur 2 gegeben ist. Andererseits ist gegenüber einer Schutzschaltung erreicht, daß die vorgeschlagene Schaltung im Vergleich zur bekannten Schaltung in ein wesentlich kleineres Raster als diese plaziert werden kann.

Zweckmäßig für die Adressierung der einzelnen Wortleitungen WL ist je eine Schaltung gemäß Figur 4. In Figur 5 ist das Zeitdiagramm der zugehörigen Taktimpulse gezeigt.

Eine Anzahl von - bezüglich ihrer Source-Drainstrecken parallel geschalteter und mit ihren Sourceanschlüssen am Bezugspotential $V_{SS}$ liegender Adressiertransistoren AT ist mittels der Drainanschlüsse ihrer Transistoren AT an einen Knoten a gelegt, der zugleich den Sourceanschluß eines Transistors 1 vomselben Typ bildet. Jeder der Adressiertransistoren AT ist mit einem durch sein Gate gegebenen Steuereingang versehen, die die Adressiereingänge AE bilden und mit entsprechenden Adressiersignalen zu beaufschlagen sind. Das Gate des zuletzt eingeführten MOS-Transistors 1 wird durch ein der Vorladung dienendes Taktsignal VT beaufschlagt. Sein Drainanschluß liegt am ersten Versorgungspotential $V_{DD}$. Ein Transfer-MOS-Feldeffekttransistor 2 verbindet die Drainanschlüsse der Adressiertransistoren AT mit dem Gate b eines (denselben Typ wie die übrigen MOS-Feldeffekttransistoren der Schaltung aufweisenden) weiteren MOS-Feldeffekttransistors 3 verbunden, dessen Source durch den für den Betrieb der Wortleitungen WL erforderlichen Takt WLT beaufschlagt ist und dessen Drain an dem Eingang E der jeweils zu steuernden Wortleitung WL liegt.

Das zum Verständnis der Wirkungsweise der Schaltung gemäß Figur 4 erforderliche Zeitdiagramm der erforderlichen Taktsignale ist in Figur 5 nebst den zugehörigen Bezeichnungen dargestellt. Besondere Ausführungen hierzu sowie zur Wirkungsweise der Treiberschaltung gemäß Figur 4 dürften im Zusammenhang mit der vorliegenden Erfindung entbehrlich sein, da sowohl die Schaltung gemäß Figur 4
als auch die aus Figur 5 ersichtliche Betriebsweise zum
Stande der Technik gehören. Im übrigen kann jede bekannte
Ansteuerungsart für die Wortleitungen WL in Verbindung mit
der Erfindung Anwendung finden.

Die in Figur 4 dargestellte Schaltung ist vor allem inbezug auf das Layout günstig.

5 Figuren
6 Patentansprüche

0058244

Patentansprüche

1.) Monolithisch integrierter MOS-Halbleiterspeicher, bei dem die in Form einer Speichermatrix in dem den Speicher aufnehmenden Halbleiterkörper angeordneten MOS-Speicherelemente einerseits über die spaltenparallel geführten Bitleitungen und andererseits über die zeilenparallel geführten Wortleitungen einzelnen durch Dekoder adressierbar sind und bei dem die einzelnen Wortleitungen im Gegensatz zu den Bitleitungen ausschließlich kapazitiv mit den zugehörigen Speicherelementen gekoppelt sind, dadurch gekennzeichnet, daß jede Wortleitung (WL) über die Serienschaltung zweier MOS-Feldeffekttransistoren (T1, T2) an ein festes Betriebspotential ($V_{ss}$) der Schaltung gelegt und die beiden MOS-Feldeffekttransistoren (T1, T2) simultan gesteuert sind, daß außerdem ein Schaltungspunkt (A) zwischen den Source-Drainstrecken dieser beiden MOS-Feldeffekttransistoren (T1, T2) über die Source-Drainstrecke eines dritten MOS-Feldeffekttransistors (T3) an ein festes zweites Betriebspotential ($V_{DD}$) gelegt und daß schließlich die Gateelektrode des dritten MOS-Feldeffekttransistors (T3) mit der betreffenden Wortleitung (WL) unmittelbar verbunden ist.

2.) Halbleiterspeicher nach Anspruch 1, dadurch gekennzeichnet, daß das über die Serienschaltung der beiden MOS-Feldeffekttransistoren (T1, T2) an die zugeordnete Wortleitung (WL) anschließbare Betriebspotential mit dem Bezugspotential ($V_{ss}$) und das andere Potential mit dem ersten Betriebspotential ($V_{DD}$) der Speicherschaltung identisch ist.

3.) Halbleiterspeicher nach Anspruch 1 oder 2, dadurch gekennzeichnet, daß die drei Transistoren (T1, T2, T3) vomselben Kanaltyp und selbstsperrend sind.

0058244

4.) Halbleiterspeicher nach einem der Ansprüche 1 bis 3, dadurch gekennzeichnet, daß das an die Gates der beiden MOS-Feldeffekttransistoren (T1, T2) zwischen der zu schützenden Wortleitung (WL) und dem Betriebspotential ($V_{SS}$) gemeinsam zu legende Signal in Form einer festen Spannung (U1) zugeführt ist.

5.) Halbleiterspeicher nach einem der Ansprüche 1 bis 4, dadurch gekennzeichnet, daß das an die Gates der beiden MOS-Feldeffekttransistoren (T1, T2) zwischen der zu schützenden Wortleitung (WL) und dem Betriebspotential ($V_{SS}$) gemeinsam zu legende Signal in Form von Taktimpulsen zugeführt wird.

6.) Halbleiterspeicher nach einem der Ansprüche 1 bis 5, dadurch gekennzeichnet, daß die an die Gates der beiden simultan zu steuernden MOS-Feldeffekttransistoren (T1, T2) zu legende Signalspannung $U_1$ entsprechend der Bedingung

$$U_T < U_1 < |V_{DD} - U_T|$$

eingestellt ist, wobei $U_T$ die Schwellspannung der Transistoren (T1, T2, T3) und $V_{DD}$ die auf das Bezugspotential ($V_{SS}$) bezogene Betriebsspannung bedeutet.

0058244

1/2

FIG 1

FIG 2

FIG 3

FIG 4

FIG 5

—— Fall 1 : ausgewählt
--- Fall 2 : nicht ausgewählt